Europäisches Patentamt

European Patent Office

Office européen des brevets

(19)

(11) Veröffentlichungsnummer: **0 304 728**
**A2**

(12) **EUROPÄISCHE PATENTANMELDUNG**

(21) Anmeldenummer: **88113005.8**

(22) Anmeldetag: **10.08.88**

(51) Int. Cl.4: **H01L 21/285 , C23C 16/30 ,
H01L 21/90**

(30) Priorität: **27.08.87 DE 3728662**

(43) Veröffentlichungstag der Anmeldung:
**01.03.89 Patentblatt 89/09**

(84) Benannte Vertragsstaaten:
**AT BE DE FR GB IT NL**

(71) Anmelder: **Siemens Aktiengesellschaft Berlin
und München
Wittelsbacherplatz 2
D-8000 München 2(DE)**

(72) Erfinder: **Kücher, Peter
Klenzestrasse 7
D-8400 Regensburg(DE)**
Erfinder: **Röska, Günther, Dr.
Roggersdorfer Strasse 35
D-8150 Holzkirchen(DE)**

(54) Verfahren zum Herstellen einer aus Aluminium oder einer Aluminium-Legierung bestehenden niederohmigen planen Metallisierung.

(57) Zur Verbesserung der Planarisierung und der Zuverlässigkeit für niederohmige Aluminium-Metallisierungen wird das mit einer Titan/Titannitrid-Doppelschicht (5, 6) als Diffusionsbarriereschicht versehene Substrat (1, 2, 3) mit Kontaktloch (4) mit einer Aluminium/Silizium-Legierung (7) versehen bzw. gefüllt und darauf eine Sandwichstruktur bestehend aus einer Folge von n Aluminium/Silizium-Schichten (9, 19, 29, 39) mit n - 1 Zwischenlagen (8, 18, 28) aus Titan aufgebracht, wobei das Schichtdickenverhältnis der Titanzwischenschichten (8, 18, 28) zur Gesamtschichtdicke d der Metallisierung sich wie 1 : 10 verhält. Die so hergestellte Multisandwich-Metallisierung wird verwendet bei VLSI-Schaltungen und erzielt bei gleichem spezifischen Widerstand eine 10 bis 100-fache höhere Lebensdauer als die sonst üblichen Aluminium/Silizium/Titan-Legierungen.

FIG 5

EP 0 304 728 A2

# Verfahren zum Herstellen einer aus Aluminium oder einer Aluminium-Legierung bestehenden niederohmigen planen Metallisierung.

Die Erfindung betrifft ein Verfahren zum Herstellen einer aus Aluminium oder einer Aluminium-Legierung bestehenden niederohmigen planen Metallisierung für hochintegrierte Halbleiterschaltungen, bei dem Aluminium als Kontaktlochfüller und eine aus Titan/Titannitrid bestehende Doppelschicht als Diffusionsbarriereschicht verwendet wird, sowie eine so hergestellte niederohmige Metallisierung.

Bedingt durch die höhere Integration von Halbleiterschaltungen (Transistoren, Kondensatoren) auf einem Chip nimmt der verfügbare Platz für das Einzelelement stetig ab. Bei der Verdrahtung von höchstintegrierten Halbleiterschaltkreisen wird daher zunehmend auch bei MOS-Schaltungen eine Mehrlagenverdrahtung notwendig. Voraussetzung dafür ist eine Planarisierung der Oberfläche der einzelnen Schichtkomponenten (Isolationsoxide, Metallisierungsschichten).

Die Zuverlässigkeit der Metallisierung wird von der Elektromigrationsbeständigkeit des Materials, des Hillockwachstums (führt zu Kurzschlüssen), von mechanischen Spannungen in der Schicht, von Lochbildung (Voids), von der Korrosion sowie der Kantenbedeckung über den Stufen und im Kontaktloch bestimmt.

Aufgabe der Erfindung ist es, ein Verfahren zur Herstellung einer niederohmigen, planarisierenden Verdrahtung mit Aluminium zur Auffüllung von Kontaktlöchern oder via holes (das sind Kontaktlöcher in Isolationsschichten zwischen zwei Metallisierungsebenen) und einer Sandwich-Aluminium-Struktur als Leiterbahnebene anzugeben, die den Anforderungen einer hohen Zuverlässigkeit genügt und durch ein konventionelles Strukturierungsverfahren hergestellt werden kann.

Für die Metallisierung von integrierten Schaltkreisen wurden bislang Aluminium-Legierungsschichten wie Aluminium/Silizium- Legierungen, Aluminium/Silizium/Titan-Legierungen, Aluminium/Kupfer- und Aluminium/Silizium/Kupfer-Legierungen verwendet. Eine solche Aluminium-Legierung auf der Basis einer Aluminium/Silizim/Titan-Legierung mit einem Anteil von 1 bis 2 Gewichtsprozent Silizium und einem Titanzusatz von kleiner 0,5 Gewichtsprozent ist beispielsweise aus der europäischen Patentanmeldung 0 110 401 bekannt.

Aus der europäischen Patentanmeldung 0 199 030 ist zur Herstellung zuverlässiger, mit hohen Stromdichten belastbarer Aluminiumkontakte ein Kontaktlochfüllverfahren bekannt, bei dem Aluminium verwendet wird, welches durch Niederdruckgasphasenabscheidung ganzflächig abgeschieden und bis auf Kontaktlochhöhe wieder zurückgeätzt wird. Wegen der im Kontaktloch befindlichen Aluminium-Füllung findet keine Schichtdickenabnahme im Kontaktloch statt, so daß auch an diesen Stellen eine Strombelastung nicht kritisch ist. Es besteht jedoch die Gefahr des Aluminiumspiking, was zu Substratkurzschlüssen führen kann.

In der deutschen Patentanmeldung P 36 40 656.2 ist zur Verbesserung der Planarisierung und der Zuverlässigkeit für niederohmige Leiterbahnen aus Aluminium vorgeschlagen worden, als Kontaktlochfüller Wolfram zu verwenden und als Leiterbahnschicht ein Metallisierungsschema, welches wegen des hohen spezifischen Widerstandes von Wolfram und der schlechten Bond- und Strukturierbarkeit als Unterschicht eine Titan/Titannitrid-Doppelschicht und als Deckschicht eine Molybdän-Silizidschicht enthält.

Bei hohem Aspektverhältnis und ungünstiger Kontaktlochform muß wegen der Bildung sogenannter key-holes oft eine Polyimidschicht abgeschieden werden und wieder zurückgeätzt werden, um eine Überätzung des Wolfram im Kontaktloch zu vermeiden. Außerdem ist der metallische Kontakt zwischen Aluminium und Wolfram unbestimmt; ein eventuell vorhandener Fluorgehalt im Wolfram (aus Wolframhexafluorid) führt zur Aluminiumkorrosion.

Sowohl das aus der europäischen Patentanmeldung 0 0199 030 bekannte Verfahren als auch das in der deutschen Patentanmeldung P 36 40 656.2 vorgeschlagene Verfahren stellen wegen der verwendeten Ausgangsmaterialien - wie Wolframhexafluorid, Triisobutylaluminium - wegen der hohen Toxizität bzw. Entzündbarkeit für Prozeßlinien eine Risikoerhöhung dar.

Die Erfindung löst die Aufgabe bzw. das Problem der Herstellung einer niederohmigen planarisierenden Verdrahtung mit Aluminium auf eine andere Weise und ist dadurch gekennzeichnet, daß nach dem Abscheiden der Titan/Titannitrid-Doppelschicht auf die mit den Kontaktlöchern versehene Anordnung als Kontaktlochfüllung ganzflächig eine Aluminium/Silizium-Legierung durch Kathodenzerstäubung abgeschieden und ganzflächig zurückgeätzt wird, wobei die Titan/Titannitrid-Schicht auf der Oberfläche als Ätzstop dient, daß darauf dann eine Folge von aus Aluminium oder aus einer Aluminium-Legierung bestehenden Schichten n mit Titan als Zwischenlagen aufgebracht wird, wobei die Anzahl der Titanzwischenschichten n - 1 beträgt und das Schichtdickenverhältnis der Titanzwischenschichten zur Gesamtschichtdicke d der Metallisierung sich wie 1 : 10 verhält. Dadurch wird gegenüber der Verwendung einer Aluminium/Silizium/Titan-Legierung, wie sie beispielsweise in der europäischen Patentanmeldung 0 110 401 beschrieben ist, eine 10 bis 100 fache höhere Lebensdauer erreicht.

Es liegt im Rahmen der Erfindung, daß die Zahl der Titanzwischenschichten (n - 1) mindestens 2 beträgt und daß bei einer Gesamtschichtdicke d der Metallisierung im Bereich von 700 nm die Schichtdicke der einzelnen Titanzwischenlage mindestens 10 nm, höchstens

$$\frac{d}{10 \, (n-1)}$$

nm beträgt. Eine Verringerung der Titan-Einzellagendicke führt zu einem Aufbrechen der Zwischenschichten, eine Vergrößerung zu einer wesentlichen Erhöhung des spezifischen Widerstandes und zu Problemen bei der Strukturierung. Eine Verringerung der Zwischenschichtenzahl erhöht zwar die Lebensdauer der Leiterbahn unter Gleichstrombedingungen, bringt jedoch eine deutliche Verkürzung der Lebensdauer bei Belastungsexperimenten unter permanenten Temperaturänderungen mit sich, wie sie bei Ein- und Ausschaltvorgängen von integrierten Schalt kreisen auftreten.

Weitere Ausgestaltungen der Erfindung, insbesondere ein besonders bevorzugtes Mehrlagensystem ergibt sich aus den Unteransprüchen.

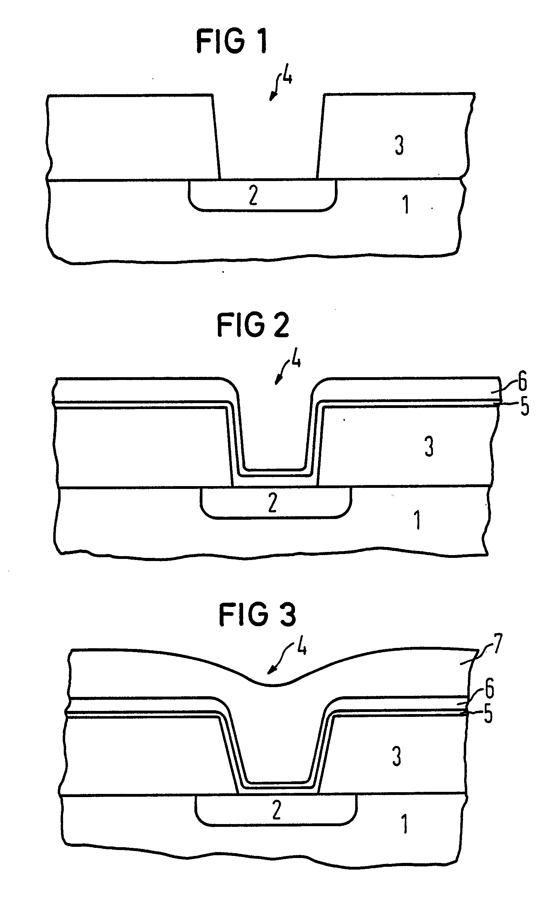

Nachfolgend soll anhand eines Ausführungsbeispiels und der Figuren 1 bis 5 die Erfindung noch näher erläutert werden. Dabei zeigen die Figuren 1 bis 5 die erfindungswesentlichen Verfahrensschritte zur Herstellung eines besonders günstigen Aluminium-Metallisierungssystems, wie es für höchstintegrierte Schaltungen sehr gut geeignet ist.

Gleiche Teile sind in den Figuren mit gleichen Bezugszeichen bezeichnet.

Figure 1: Auf das mit dem Bezugszeichen 1 gekennzeichnete Siliziumsubstrat, in dem sich eine n$^{+}$-dotierte, zu kontaktierende Zone 2 (Wanne) befindet, wird eine als Isolationsschicht dienende S iO$_2$-Schicht 3 aufgebracht, in die das Kontaktloch 4 mit einem Durchmesser von ca. 0,9 $\mu$m im Bereich der dotierten Zone 2 eingeätzt wird.

Figure 2: In der ersten Metallisierungsebene müssen die Kontaktlöcher mit hohem Aspektverhältnis und kleinem Kontaktlochdurchmesser eine gute Kantenbedeckung der Metallisierung und eine hohe Zuverlässigkeit aufweisen, das heißt, es muß eine gute Elektromigrationsbeständigkeit vorhanden sein und die Hillockdichte und -größe soll vermindert werden (Hillockwachstum kann intermetallische Kurzschlüsse verursachen). Es wird zunächst auf die Anordnung 1, 2, 3, 4 eine Barriereschicht 5, 6 zum Beispiel aus einer Titan (5)/Titannitrid (6)-Doppelschicht, die auch als Ätzstop für die später erfolgende Rückätzung der Aluminium-Silizium-Legierung (7) geeignet ist, abgeschieden. Diese Schicht 5, 6 macht einen niederohmigen Kontakt zur dotierten Zone 2 und stellt zugleich bei späteren Temperaturschritten eine Diffusionsbarriere zu Silizium (2) her.

Figur 3: Es folgt nun ein planarisierender Aufstäubprozeß (Sputtern), durch den ganzflächig und das Kontaktloch 4 bedeckend eine Aluminium/Silizium-Legierung 7 mit einem Anteil von 1 Gewichtsprozent Silizium aufgebracht wird. Dabei werden Prozeßtemperaturen von ca. 500 °C wegen der hohen Abscheiderate nur für ca. 10 bis 20 Sekunden erreicht, im Gegensatz zu der Aluminiumabscheidung, welche aus der Gasphase zum Beispiel durch thermische Zersetzung von Triisobutylaluminium erfolgt. Bei dem hier beschriebenen Verfahren können auch Materialien oder Legierungen mit niedrigem Schmelzpunkt eingesetzt werden, die sich mit reaktivem Ionenätzen leicht strukturieren lassen. Das Sputtern erfolgt zum Beispiel unter Verwendung eines Sinter-Targets.

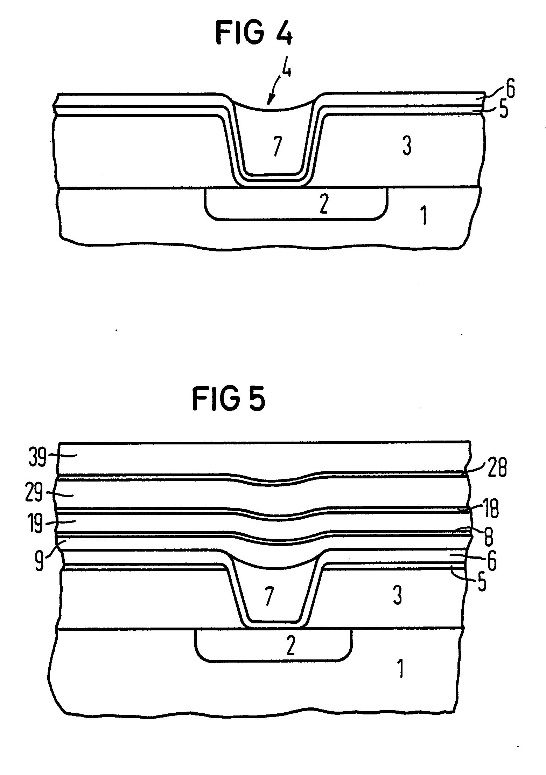

Figure 4: Die auf der Oberfläche vorhandene Aluminium/Silizium- Schicht 7 wird zurückgeätzt bis nur noch das Kontaktloch 4 mit der Aluminium/Silizium-Legierung 7 gefüllt bleibt. Dabei kann auf bekannte Ätzprozesse mit Bortrichlorid und Chlor zurückgegriffen werden. Im Gegensatz zu einer Auffüllung des Kontaktloches mit aus der Gasphase abgeschiedenem Wolfram (Verwendung von Wolframhexafluorid) ist für die planarisierende Abscheidung durch die Kathodenzerstäubung (Sputtern) und anschließende Rückätzung bei Aluminium/Silizium kein Anlagenwechsel erforderlich. Außerdem dient die Titan/Titannitrid-Doppelschicht 5, 6 als Ätzstop.

Figure 5: Im weiteren Prozeßverlauf wird nun eine hochmigrationsbeständige Multisandwich-Metallisierung aus Aluminium oder einer Aluminium/Legierung, vorzugsweise Aluminium mit 1 Gewichtsprozent Silizium-Anteil, und Titan aufgebracht. Im vorliegenden Fall besteht die Multisandwich-Metallisierung bei einer Gesamtschichtdicke von 700 nm aus drei Titan-Zwischenlagen 8, 18, 28 von je 20 nm Dicke und aus vier Aluminium/Silizium-Lagen 9, 19, 29, 39. Der spezifische Widerstand dieser Metallisierung beträgt ca. 3,7 $\mu$Ohm cm und ist damit nicht größer als der einer migrationsfesten Aluminiumlegierung mit 1 % Silizium und 0,2 % Titan, wie sie zum Beispiel in der europäischen Patentanmeldung 0 110 401 beschrieben wird. Die Multisandwich-Leiterbahn nach der Lehre der Erfindung weist aber eine 10 bis 100-fach höhere Lebensdauer auf. Wichtig bei der erfindungsgemäßen Konfiguration ist, daß die geometrischen Korrelationen, das heißt die Anzahl der Titanzwischenschichten und das Dickenverhältnis zur Gesamtschichtdicke d, auch bei geänderter Gesamtschichtdicke d eingehalten werden.

**Ansprüche**

1. Verfahren zum Herstellen einer aus Aluminium oder einer Aluminium-Legierung bestehenden niederohmigen planen Metallisierung für hochintegrierte Halbleiterschaltungen, bei dem Aluminium als Kontaktlochfüller und eine aus Titan/Titannitrid bestehende Doppelschicht als Diffusions-Barriereschicht verwendet wird, **dadurch gekennzeichnet**, daß nach dem Abscheiden der Titan/Titannitrid-Doppelschicht (5, 6) auf die mit den Kontaktlöchern (4) versehene Anordnung (1, 2, 3) als Kontaktlochfüllung ganzflächig eine Aluminium/Silizium-Legierung (7) durch Kathodenzerstäubung niedergeschlagen und ganzflächig zurückgeätzt wird, wobei die Titan/Titannitrid-Schicht (5, 6) auf der Oberfläche als Ätzstop dient, daß darauf dann eine Folge von aus Aluminium oder aus einer Aluminium-Legierung bestehenden Schichten n (9, 19, 29, 39) mit Titan als Zwischenlagen (8, 18, 28) aufgebracht wird, wobei die Anzahl der Titanzwischenschichten (8, 18, 28) n - 1 beträgt und das Schichtdickenverhältnis der Titanzwischenschichten (8, 18, 28) zur Gesamtschichtdicke d der Metallisierung sich wie 1 : 10 verhält.

2. Verfahren nach Anspruch 1, **dadurch gekennzeichnet**, daß die Zahl der Titanzwischenschichten (8, 18, 28) mindestens 2 beträgt.

3. Verfahren nach Anspruch 1, **dadurch gekennzeichnet**, daß bei einer Gesamtschichtdicke d der Metallisierung im Bereich von 700 nm die Schichtdicke der einzelnen Titanzwischenlage (8, 18, 28) mindestens 10 nm, höchstens

$$\frac{d}{10 \ (n-1)}$$

nm, beträgt.

4. Verfahren nach einem der Ansprüche 1 bis 3, **dadurch gekennzeichnet**, daß als Kontaktlochfüller (7) und für die Schichtenfolge (9, 19, 29, 39) eine Aluminium/Silizium-Legierung mit einem Siliziumanteil von 1 Gewichtsprozent verwendet wird.

5. Verfahren nach einem der Ansprüche 1 bis 4, **dadurch gekennzeichnet**, daß die Abscheidung der Metallisierungsfolge (8, 9, 18, 19, 28, 29, 39) durch Kathodenzerstäubung erfolgt.

6. Verfahren nach einem der Ansprüche 1 bis 5, **dadurch gekennzeichnet**, daß der Rückätzprozeß der Aluminium/Silizium-Legierung (7) nach der Kontaktlochfüllung durch reaktives Ionenätzen in einem Bortrichlorid/Chlor-Gemisch durchgeführt wird.

7. Aus Aluminium, Silizium und Titan bestehende niederohmige Metallisierung für hochintegrierte Halbleiterschaltungen mit einer als Diffusionsbarriere zum Siliziumsubstrat wirkenden Titan/Titannitrid-Doppelschicht, **dadurch gekennzeichnet**, daß der Kontaktlochfüller (7) aus einer Aluminium/Silizium-Legierung besteht und daß auf der Substratoberfläche (1, 2, 3) über der Titan/Titannitrid-Doppelschicht (5, 6) eine Sandwichstruktur bestehend aus einer Folge n von Aluminium- oder Aluminium-Legierungsschichten (9, 19, 29, 39) mit n - 1 Zwischenlagen (8, 18, 28) aus Titan angeordnet ist, wobei die Anzahl der Titanzwischenschichten n -1 beträgt und das Schichtdickenverhältnis der n - 1 Titanzwischenschichten zur Gesamtschichtdicke d der Metallisierung n + (n - 1) sich wie 1 : 10 verhält.

8. Metallisierung mit einem spezifischen Widerstand von 3,7 $\mu$ Ohm cm nach Anspruch 7, **dadurch gekennzeichnet**, daß bei einer Gesamtschichtdicke von 700 nm die Schichtenfolge aus vier Aluminium/Silizium-Schichten (9, 19, 29, 39) mit drei dazwischenliegenden Titanschichten (8, 18, 28) von je 20 nm Schichtdicke besteht.

## FIG 1

## FIG 2

## FIG 3

# FIG 4

# FIG 5